# FASCICULE DE BREVET EUROPEEN

(11) **EP 2 855 737 B1**
(45) Date de publication et mention de la délivrance du brevet: **20.04.2016**
(21) Numéro de dépôt: 13727596.2
(22) Date de dépôt: 05.06.2013
(51) Int. Cl.: C25D 1/10, C25D 7/00, C25D 1/00, C25D 5/02, G03F 1/00, G03F 7/00, G03H 1/02, G03H 1/04, G03H 1/00

(54) **PROCÉDÉ DE FABRICATION DE PIÈCES MICROMÉCANIQUES DIFFICILEMENT REPRODUCTIBLES ET PIÈCES MICROMÉCANIQUES FABRIQUÉES SELON CE PROCÉDÉ**
VERFAHREN ZUR HERSTELLUNG VON FEINMECHANIKTEILEN, DIE SCHWER NACHZUBILDEN SIND, SOWIE MIT DIESEM VERFAHREN HERGESTELLTE FEINMECHANIKTEILE
METHOD OF MANUFACTURING HARDLY REPRODUCIBLE PIECES OF MICROMECANICS AND PIECES PRODUCED BY SAID METHOD

(30) Priorité: 05.06.2012 CH 775122012
(43) Date de publication de la demande: 08.04.2015
(73) Titulaire: Mimotec S.A., 1950 Sion (CH)
(72) Inventeur: LORENZ, Hubert, CH-1950 Sion (CH); GENOLET, Grégoire, CH-1926 Fully (CH); GLASSEY, Marc-André, CH-1967 Bramois (CH); WINKLER, Pascal, CH-2072 Saint-Blaise (CH)
(74) Mandataire: P&TS SA (AG, Ltd.)
(86) Numéro de dépôt international: PCT/EP2013/061621
(87) Numéro de publication internationale: WO 2013/182615

(56) Documents cités:
- WO-A2-2010/085052
- WO-A2-2011/031047
- BACHER W ET AL: "The LIGA technique and its potential for microsystems", INDUSTRIAL ELECTRONICS, CONTROL AND INSTRUMENTATION,, vol. 3, 5 septembre 1994 (1994-09-05), pages 1466-1471, XP010137598, DOI: 10.1109/IECON.1994.398030 ISBN: 978-0-7803-1328-6
- KREUTZ ET AL: "Tailoring of surface properties by removal and deposition with laser radiation", APPLIED SURFACE SCIENCE, ELSEVIER, AMSTERDAM, NL, vol. 86, no. 1-4, 1 février 1995 (1995-02-01), pages 266-277, XP005278383, ISSN: 0169-4332, DOI: 10.1016/0169-4332(94)00396-3
- JOONG-MOK PARK ET AL: "Fabrication of submicron metallic grids with interference and phase-mask holography", JOURNAL OF MICRO/NANOLITHOGRAPHY, MEMS AND MOEMS, vol. 10, no. 1, 1 janvier 2011 (2011-01-01), XP055013993, ISSN: 1932-5150, DOI: 10.1117/1.3541794

## Description

### Domaine technique

La présente invention concerne la fabrication de pièces micromécaniques difficilement reproductibles. La présente invention concerne en particulier la fabrication de pièces protégées par des éléments masqués.

### Etat de la technique

Dans de nombreux domaines de fabrication, il est nécessaire de fabriquer des pièces difficiles à reproduire par un faussaire ou un contrefacteur. En horlogerie par exemple, les progrès techniques des contrefacteurs sont tels que même des montres mécaniques complexes sont parfois reproduites avec un niveau de réalisme important par des contrefacteurs peu scrupuleux. Les consommateurs ou même parfois les détaillants peinent parfois à distinguer facilement une montre originale d'un faux. D'autres domaines micromécaniques, notamment dans les domaines du luxe, de la maroquinerie, de la lunetterie etc souffrent de problèmes similaires. Par ailleurs, la valeur de certaines pièces mécaniques dépend parfois presque exclusivement de la facilité avec laquelle un utilisateur peut distinguer s'il s'agit d'un original ou d'une reproduction. C'est par exemple le cas de sceaux ou de scellés qu'une autorité appose sur un paquet, un objet, une porte etc afin de détecter un accès non autorisé.

Différentes techniques existent afin de rendre un objet difficile à reproduire. Des techniques d'impression sophistiquées sont utilisées par exemple pour protéger des billets de banque ou des timbres-poste. Ces techniques d'impression sont difficiles à appliquer sur des pièces métalliques, notamment des pièces métalliques, de petites taille, des pièces soumises à une usure ou dont l'aspect esthétique ne doit pas être altéré. L'usage de composants électroniques, par exemple de transpondeurs RFID, est également largement répandu, mais pose le problème de la liaison inamovible entre le transpondeur et l'objet à protéger, et la difficulté à cacher complètement le transpondeur sur certaines pièces. D'autres techniques mettent en oeuvre par exemple l'utilisation d'un motif de bulles aléatoire et unique apposé sur les produits.

On connait également des exemples de pièces horlogères protégées par des motifs de lignes gravées supposées difficiles à reproduire. Toutefois, des artisans spécialisés dans le guillochage, ou des machines de guillochage modernes, parviennent souvent à reproduire des motifs complexes, même lorsqu'il s'agit de fabriquer un nombre de reproductions limité.

On connait également des techniques de protection par hologrammes de sécurité ou plus récemment par marquage « covert laser readable » (CLR). Il s'agit dans les deux cas de modifier l'aspect tridimensionnel de la surface d'un élément afin de faire apparaitre un motif lorsqu'un flux de lumière cohérente atteint la surface modifiée. La technologie CLR offre notamment l'avantage de nécessiter uniquement la modification d'une très petite surface pour faire apparaitre un motif parfaitement visible sous certaines conditions d'illumination. Elle est notamment utilisée sur des étiquettes ou des emballages de produits à protéger contre la contrefaçon. Elle requiert cependant la fabrication de structures tridimensionnelles de dimension extrêmement précises, notamment de structures dont l'épaisseur doit correspondre au quart de longueur d'onde de la lumière incidente. La fabrication de motifs avec une telle précision est difficile, notamment sur des pièces mécaniques elles-mêmes difficiles à réaliser.

US20100294146 décrit un procédé de fabrication de timbre nanostructuré pour la protection d'objets contre la contrefaçon.

US20090162756 décrit un procédé de fabrication d'un hologramme volumique utilisé pour l'authentification d'objets et la sécurité.

EP1297491B1 décrit une structure diffractive utilisée pour protéger un dispositif contre la contrefaçon. La structure diffractive n'est pas réalisée par LIGA.

JP2005345319 décrit un sceau holographique pour la protection des parties externes d'une montre contre la contrefaçon.

WO2011/031047 concerne un procédé de création d'un timbre muni d'un micro-motif pour moulage à injection. Le but est ici de fabriquer des structures décoratives, similaires à des hologrammes, pour des appareils électroménagers. Le procédé comprend une étape de formation d'un micro-motif sur un substrat, et une étape d'application d'une plaque métallique afin de transférer le motif sur la plaque qui servira ensuite pour le moulage. Le substrat peut être fabriqué par exemple par un procédé LIGA ou par d'autres procédés équivalents. Le procédé LIGA permet de réaliser des motifs avec une résolution latérale typique de quelques microns et de quelques dizaines de microns en épaisseur. Les dimensions des détails les plus fins qui peuvent être produits se situent donc dans le domaine du visible. Ce procédé permet donc de réaliser un hologramme ou un autre motif sans irisation. En raison de la résolution modérée, ce procédé ne convient cependant pas pour fabriquer des structures avec des motifs plus fins que la résolution de l'oeil. En particulier, le procédé comprend l'application d'une couche de photoresist sur un substrat, dont l'épaisseur détermine l'épaisseur finale des motifs obtenus. Il est cependant difficile ou impossible de contrôler avec précision l'épaisseur de la couche de résine déposée. Par conséquent, il est difficile ou impossible de contrôler l'épaisseur des motifs produits avec ce procédé.

Comme on le verra, il serait cependant avantageux de disposer d'un procédé de fabrication de pièces permettant de contrôler l'épaisseur et les autres dimensions des structures produites avec une précision de l'ordre de quelques nanomètres ; en effet une telle précision permettrait de réaliser des structures avec des dimensions correspondant à la longueur d'onde de la lumière visible, ou au quart de la longueur d'onde de la lumière visible, et donc de réaliser des structures d'interférence impossibles à réaliser avec la technologie de WO2011/031047.

La résolution latérale des motifs réalisés avec le procédé LIGA de WO2011/031047 étant importante, la surface totale de la structure nécessaire pour afficher un texte ou un logo imprimé avec cette technologie doit donc être relativement importante. Ce procédé ne convient donc pas ou difficilement au marquage de pièces mécaniques de petites dimensions, par exemple au marquage de pièce fonctionnelles en microtechniques telle qu'un composant horloger.

WO2010/085052 concerne un autre procédé de création de micro-motif pour un appareil ménager. Le procédé décrit permet de réfléchir différentes longueurs d'ondes ou couleurs de lumière du micro-motif en fonction de l'angle d'incidence de l'éclairage. Ce document prévoit l'application d'une couche de nickel ou de cuivre suivie d'un électroformage : il n'y a pas d'illumination ni de photomasque à cette étape. A nouveau, l'épaisseur des motifs produits dépend de l'épaisseur d'une couche sensible à la lumière, qui est impossible à contrôler avec une précision nanométrique.

Le document « the liga technique and potential for microsystems », de BACHER W ET AL, Publié en Allemagne le 05.09.1994 concerne la technologie LIGA en tant que tel, et plus particulièrement certains avantages inhérents à cette technologie.

Le document « Tailoring of surface properties byremoval and déposition with laser radiation », de KREUTZ ET AL, publié en Allemagne le 01.02.1995, décrit une pluralité de méthodes utilisant la photolithographie par laser. En outre, l'exemple présenté en relation avec un masque comporte l'utilisation d'un seul masque.

Le document « Fabrication of submicron metallic grids with interferance and phase-mask holography », de JOONG-MOK PARK ET AL, publié le 01.01.2011, décrit un mode de réalisation de grille métallique submicronique par technologie holographique.

Un problème des nombreuses solutions utilisées pour l'authentification d'objets est celui du lien entre l'objet à protéger et l'élément de protection. Si ce lien n'est pas inamovible et permanent, on risque de voir apparaitre un trafic d'éléments de protection qui peuvent par exemple être récupérés sur des objets en fin de vie ou des invendus pour être apposés sur des objets non authentiques.

Il est aussi nécessaire que la protection de l'objet contre la contrefaçon n'altère pas l'aspect esthétique de l'objet. Cette exigence est particulièrement cruciale pour les objets de luxes, par exemple des pièces de montre etc. Il est donc souhaitable de réaliser une protection de petite taille, pouvant être placée sur des petites pièces. Il est souhaitable que le marquage soit effectué avec un motif suffisamment fin pour être quasi imperceptible à l'oeil nu.

Il est cependant nécessaire que l'utilisateur puisse lorsqu'il le désire vérifier facilement et si possible sans devoir recourir à un appareil supplémentaire complexe si une pièce est authentique ou non.

Il existe aussi un besoin pour un procédé de fabrication de pièces protégées contre la reproduction qui soit applicable sans surcout important à une large gamme de pièces mécaniques, y compris des pièces de forme complexes telles que par exemple des éléments du mouvement ou de l'habillage d'une montre, etc. Le procédé ne doit pas altérer le fonctionnement mécanique de la pièce, ni modifier sa masse ou son moment d'inertie de façon significative.

### Bref résumé de l'invention

Un but de la présente invention est de proposer un procédé de fabrication de pièces difficiles à reproduire qui soit exempt des limitations des procédés ci-dessus, ou qui permette d'atteindre au moins certains des buts mentionnés.

Selon l'invention, ces buts sont atteints notamment au moyen d'un procédé et d'une pièce selon les caractéristiques des revendications indépendantes correspondantes.

Selon un aspect, ces buts sont notamment atteints au moyen d'un procédé de fabrication de pièce comportant les étapes suivantes :
a) nanostructuration d'un motif CLR;
e) déposition d'une couche conductrice par-dessus un substrat respectivement par-dessus des portions de couche diffractive sur un substrat ;
f) déposition d'une deuxième couche de résine photosensible ;
g) illumination de ladite deuxième couche de résine photosensible au travers d'un deuxième photomasque (9), de manière à supprimer sélectivement des portions de ladite deuxième résine photosensible ;
h) déposition de matière par électroformage au-dessus de ladite couche conductrice, entre les portions subsistantes de deuxième résine photosensible ;
i) libération de la pièce par enlèvement au moins de la deuxième résine photosensible.

Cette solution présente notamment l'avantage par rapport à l'art antérieur de garantir la non-reproductibilité d'un objet par deux mesures différentes :
- d'une part, l'apposition d'un motif CLR, c'est-à-dire d'un motif tridimensionnel masqué difficile à reproduire, mais dont la présence peut être facilement constatée en l'illuminant au soleil ou de préférence au moyen d'un faisceau de lumière cohérente, par exemple un pointeur laser ;
- d'autre part, par la fabrication de la pièce elle-même au moyen d'une technologie qui permet de générer des pièces à la géométrie complexe, difficiles à reproduire avec des technologies d'usinages classiques par enlèvement de copeau ou par électroérosion.

Cette solution permet en outre de marquer des pièces de précision fabriquées par électroformage et par illumination d'une couche photosensible avec un motif CLR. Il est donc possible d'apposer un tel motif sur des pièces de petites dimensions, fabriquées précisément, et qui seraient difficiles à marquer autrement.

La protection provient au moins en partie du fait que la fabrication d'une reproduction nécessite impérativement l'accès ou la reproduction de deux photomasques distincts - l'un pour la fabrication de la pièce par la technologie LIGA, l'autre pour le motif tridimensionnel CLR. La réalisation de tels photomasques implique des coûts importants qui ne se justifient pas pour un contrefacteur souhaitant réaliser un nombre de reproductions limité et qui ne dispose en général pas des deux technologies LIGA et CLR nécessaires.

L'utilisation d'une étape distincte pour la réalisation du motif CLR permet notamment de réaliser un motif CLR beaucoup plus fin que ce qui pourrait être obtenu avec la technologie LIGA. En particulier, il est possible de réaliser ainsi un motif d'épaisseur parfaitement contrôlée, indépendante de l'épaisseur d'une couche de résine à appliquer, permettant ainsi de réaliser des motifs diffractifs dépendant de la longueur d'onde de la lumière réfléchie, et qui seraient impossibles à réaliser en LIGA ou avec d'autres techniques conventionnelles.

Par motif CLR, on entend dans le texte un motif « covert laser readable », c'est-à-dire un motif caché, pratiquement invisible à l'oeil nu et dont la présence peut être constatée lorsque ce motif est illuminé avec un laser da manière à ce que les interférences entre la lumière réfléchie à différentes distances génère une image qui n'existe pas dans le motif CLR apposé.

Selon une caractéristique de l'invention, le motif CLR est donc réalisé en premier, avant de réaliser la pièce sur laquelle ce motif est apposé.

Egalement de manière avantageuse, la couche diffractive est déposée sur un substrat recouvert d'une couche conductrice, elle-même sélectivement recouverte d'une troisième couche de résine photosensible.

### Brève description des figures

Des exemples de mise en oeuvre de l'invention sont indiqués dans la description illustrée par les figures annexées dans lesquelles :
La figure 1 illustre une première étape du procédé de l'invention.
La figure 2 illustre une deuxième étape du procédé de l'invention.
La figure 3 illustre une troisième étape du procédé de l'invention.
La figure 4 illustre une quatrième étape du procédé de l'invention.
La figure 5 illustre une cinquième étape du procédé de l'invention.
La figure 6A illustre une sixième étape du procédé de l'invention.
La figure 6B illustre une variante de réalisation dans laquelle la couche diffractive est constituée de plusieurs niveaux.
La figure 7 illustre une septième étape du procédé de l'invention.
La figure 8 illustre une huitième étape du procédé de l'invention.
La figure 9A illustre une neuvième étape du procédé de l'invention.
La figure 9B illustre une variante dans laquelle la couche de résine photosensible est utilisée pour fournir une inscription.
La figure 9C illustre une variante dans laquelle une couche de résine photosensible épaisse définit l'insert et une couche de résine photosensible fine définit une inscription.
La figure 10 illustre une dixième étape du procédé de l'invention.
La figure 11 illustre une onzième étape du procédé de l'invention.
La figure 12 illustre une douzième étape du procédé selon un deuxième mode de réalisation de l'invention.
La figure 13 illustre une première étape du procédé selon un deuxième mode de réalisation de l'invention.
La figure 14 illustre une troisième étape du procédé selon un deuxième mode de réalisation de l'invention.
La figure 15 illustre une quatrième étape du procédé selon un deuxième mode de réalisation de l'invention.
La figure 16 illustre une cinquième étape du procédé selon un deuxième mode de réalisation de l'invention.
La figure 17 illustre une sixième étape du procédé selon un deuxième mode de réalisation de l'invention.
La figure 18 illustre une septième étape du procédé selon un deuxième mode de réalisation de l'invention.
La figure 19 illustre une huitième étape du procédé selon un deuxième mode de réalisation de l'invention.
La figure 20 illustre une neuvième étape du procédé selon un deuxième mode de réalisation de l'invention.
La figure 21 illustre une dixième étape du procédé selon un deuxième mode de réalisation de l'invention.
La figure 22 illustre une onzième étape du procédé selon un deuxième mode de réalisation de l'invention.
La figure 23 illustre une douzième étape du procédé selon un deuxième mode de réalisation de l'invention.
La figure 24 illustre une treizième étape du procédé selon un deuxième mode de réalisation de l'invention.
La figure 25 illustre un exemple de pièces réalisée selon le procédé de l'invention.

### Exemple(s) de mode de réalisation de l'invention

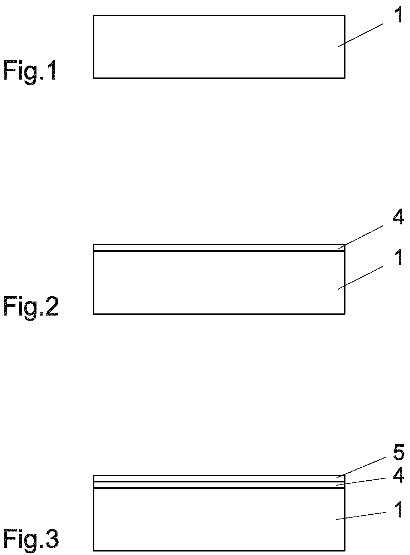

Un premier mode de réalisation de l'invention va être décrit à l'aide des figures 1 à 11. Les dessins sont schématiques uniquement et les proportions ne sont pas nécessairement exactes.

Sur la figure 1, un substrat planaire est préparé, par exemple un substrat de verre, de silicium, de métal etc. Le substrat planaire peut être de forme carrée , rectangulaire mais de préférence il sera rond.

Sur la figure 2, une première couche 4 est déposée sur ce substrat, par exemple une couche d'oxyde de silicium produite par oxydation, une couche d'aluminium, etc. La couche 4 peut être une couche diffractive, la caractéristique diffractive étant obtenue par sa hauteur subsistante après gravure. L'épaisseur de cette couche est contrôlée avec précision et correspond de préférence au quart de la longueur d'onde de la lumière pour laquelle le motif CLR est destiné.

Dans une variante de l'invention, un substrat de type SOI est utilisé qui permet d'éviter l'étalement d'une première couche 4 sur un substrat, étant dit que le substrat SOI est déjà un assemblage d'une fine couche de silicium sur une couche d'oxyde enterrée dans un substrat en silicium.

Dans l'étape suivante illustrée sur la figure 3, une première couche de résine photosensible 5 (photoresist) est déposée. Cette couche est avantageusement fine, de préférence inférieure à 2 µm.

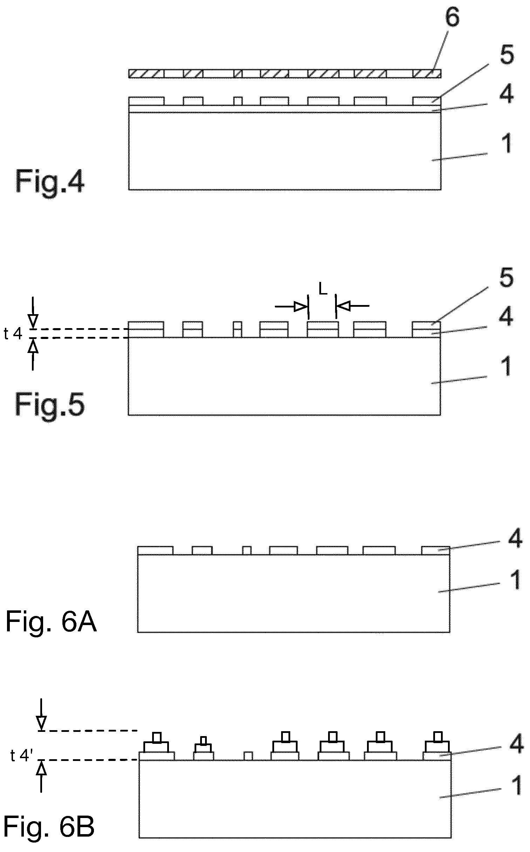

Dans l'étape suivante illustrée sur la figure 4, cette couche de résine photosensible 5 est illuminée au travers d'un premier photomasque 6, à l'aide d'une lumière ultraviolette, visible, de rayons X etc. Le photomasque 6 comporte des ouvertures permettant aux ondes électromagnétiques d'atteindre la résine photosensible 5 pour dupliquer le motif du masque, afin de pouvoir ensuite attaquer chimiquement la résine et la supprimer aux endroits exposés. La résine subsiste sous les portions opaques du photomasque. La résolution du premier photomasque 6, c'est-à-dire la taille minimale des ouvertures ou la distance entre deux ouvertures, est avantageusement inférieure à 10 microns. Le photomasque 6 comporte avantageusement de larges ouvertures délimitant une ou plusieurs portions non contiguës, la taille de chaque portion étant inférieure à 4 mm², de préférence de 1mm² +- 20%. La surface totale du substrat, ainsi que la surface de chaque pièce, peut être largement supérieure à la surface de la ou des portions, en sorte que ces portions peuvent n'occuper qu'une portion limitée de la face supérieure de chaque pièce. Dans un exemple, la surface de chaque pièce est supérieure à 10mm². Chaque portion comporte un motif correspondant à un marquage de type CLR, c'est-à-dire un motif de diffraction permettant de faire apparaitre une image ou un texte sur la pièce lorsque celle-ci est illuminée. Les différents motifs peuvent être identiques ou différents les uns des autres.

Dans l'étape suivante illustrée sur la figure 5, la couche diffractive 4 est gravée aux endroits non protégés par la résine 5. La résine 5 est ensuite retirée au cours de l'étape illustrée sur la figure 6A, de manière à laisser subsister une ou plusieurs portions avec des motifs CLR en bosse de couche diffractive 4 sur le substrat 1.

La dimension t4 montre l'épaisseur de la couche diffractive 4, qui est sensiblement égale à λ/4 dans cet exemple de manière à ce que les interférences entre la lumière réfléchie par les sommets et par les creux de la couche diffractive créé des interférences. Dans cet exemple, on utilise avantageusement un laser de longueur d'onde (λ) compris entre 130 et 900 nm. Comme on le voit, l'épaisseur de cette couche est indépendante de l'épaisseur de la couche de photoresist 5 préalablement déposée puis retirée.

La figure 6B montre une variante de réalisation dans laquelle la couche diffractive 4 est constituée de plusieurs niveaux (trois niveaux dans cet exemple). Ces niveaux sont avantageusement réalisés par étapes successives, tel que préalablement décrit pour l'exemple de la figure 6A avec un seul niveau.

Un agencement à plusieurs niveaux permet une plus grande souplesse pour la réalisation du motif projeté. Par exemple, dans certaines réalisations à un seul niveau, il est possible que l'image projetée soit polluée par une image miroir également projetée. L'utilisation de plusieurs niveaux permet de compenser cet effet, en général non souhaité. L'épaisseur totale des multiples niveaux correspond avantageusement à environ λ/4, soit trois niveaux d'environ λ/12 chacun. Un nombre de niveaux différents peut être utilisé.

Dans une variante non illustrée, la structure CLR illustrée sur la figure 6A ou celle illustrée sur la figure 6B est obtenue directement par une technologie de type NIL (« nanoimprint lithography »), c'est-à-dire par emboutissage d'un polymère sur un substrat à l'aide d'un tampon à très haute résolution réalisé préalablement, par exemple par gravure plasma et/ou chimique.

De manière optionnelle, il est possible de personnaliser ce motif, par exemple en supprimant sélectivement une ou plusieurs bosses de la couche diffractive, afin de créer un motif individuel sur chaque pièce ou sur différentes séries sans devoir modifier le premier photomasque 6.

Le motif obtenu jusque-là et illustré sur les figures 6A et 6B est appelé « motif CLR », parce que sa géométrie correspond à celle du motif CLR que l'on souhaite réaliser. On notera cependant que la surface en creux et en bosse qui apparait sur cette figure n'est pas celle qui sera utilisée dans la pièce finale, mais qu'elle sert uniquement à la fabrication de cette pièce finale. Le motif CLR en surface de la pièce intermédiaire illustrée sur les figures 6A et 6B n'a donc pas besoin d'être particulièrement réfléchissant.

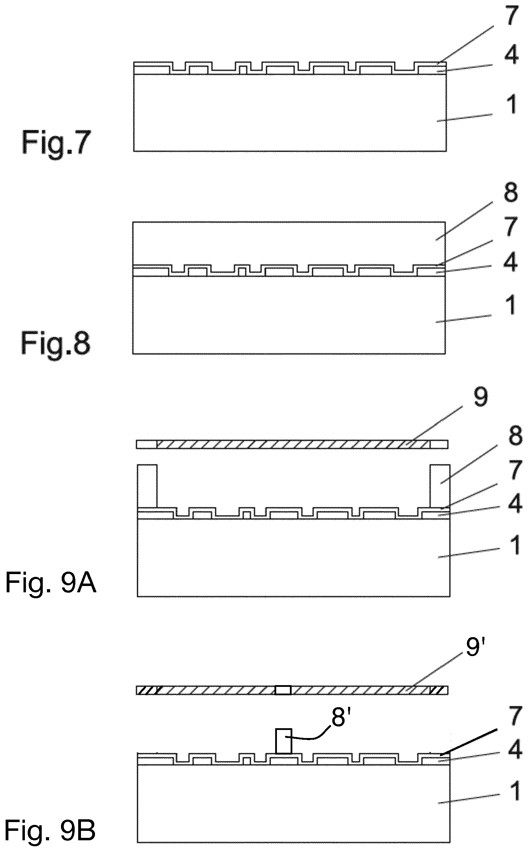

Ce motif CLR est ensuite recouvert d'une couche conductrice 7, par exemple une couche de chrome, d'or etc (figure 7).

Une deuxième couche de résine photosensible 8 est ensuite déposée sur cette couche 7 (Figure 8). Cette couche est avantageusement nettement plus épaisse que la première couche de résine 5, par exemple entre 100 et 1500 microns. Son épaisseur détermine l'épaisseur de la pièce finale (mais pas celle du motif CLR).

Selon la figure 9A, la deuxième couche de résine photosensible 8 est ensuite illuminée au travers d'un deuxième photomasque 9 au moyen de lumière visible, ultraviolette ou de rayons X par exemple. Les ouvertures dans le deuxième photomasque déterminent le contour de la ou des pièces fabriquées.

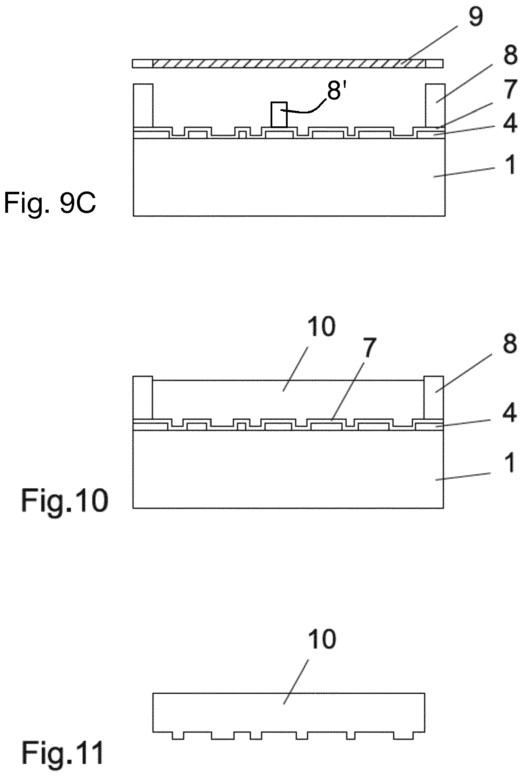

Les figures 9B et 9C illustrent une variante dans laquelle une couche de résine photosensible 8' a tout d'abord été illuminée avec un photomasque 9' sur la figure 9B, tandis qu'une deuxième couche de résine photosensible 8 d'épaisseur différente à celle de la couche 8' est ensuite illuminée avec un deuxième photomasque 9. La couche moins épaisse 8' peut être déposée avant la couche plus épaisse 8, comme illustré ; avantageusement, la couche moins épaisse 8' est toutefois déposée après la couche plus épaisse 8. La couche moins épaisse 8' peut être utilisée pour fournir une inscription ou motif, comme par exemple une référence de pièce, un numéro de série, un logo, une marque, etc., avantageusement directement visible sans éclairage spécifique. Ce motif visible sur ou autour de la surface CLR peut ainsi être réalisé par technique LIGA, par exemple sous la forme d'un trou borgne. L'utilisation de telles inscriptions visibles en plus du motif CLR invisible permet l'obtention d'un deuxième niveaux de sécurisation.

Selon la figure 10, les volumes entres les portions de deuxième résine 8 qui subsistent après l'illumination au travers du deuxième photomasque 9 sont ensuite remplies de métal, par exemple d'or, de cuivre, de nickel, d'un alliage de nickel, ou d'un autre matériau, par une opération d'électroformage (galvanisation par électrodéposition), sur toute l'épaisseur de la couche de résine subsistante.

Le métal 10 électroformé peut ensuite être rectifié,percé ou subir toute sorte d'opération d'usinage.

Comme illustré sur la figure 11, la pièce 10, ou les pièces sur un même substrat, sont ensuite libérées en enlevant la résine 8, le substrat 1, la couche diffractive 4 et la couche conductrice 7. Il subsiste ainsi une pièce 10 dont la face inférieure sur la figure est munie d'au moins une portion avec un motif en relief déterminé par le premier photomasque 6, de manière à constituer un motif CLR invisible ou peu visible à l'oeil nu, mais dont la présence peut être très facilement constatée en illuminant la pièce avec une source de lumière cohérente, par exemple un simple pointeur laser.

La pièce ainsi réalisée peut être par exemple un composant micromécanique, par exemple un élément de pièce horlogère, tel qu'un composant du mouvement comme la roue d'échappement, une roue, un pont, une platine, une bascule etc, ou un élément d'habillage tel qu'une applique de cadran, un réhaut, une aiguille etc. La pièce 10 peut aussi être un sceau ou scellé pour sceller une porte ou un paquet afin de vérifier s'il a été ouvert.

La protection de la pièce contre la contrefaçon est obtenue par deux moyens distincts :
- D'une part, le motif CLR appliqué grâce au premier photomasque 6 est difficile à reproduire. Même en connaissant l'image qui doit être réfléchie par ce motif, il est difficile de calculer le motif qui doit être gravé. La fabrication elle-même requiert des technologies rarement disponibles chez les contrefacteurs.
- D'autre part, la fabrication par la technique LIGA c.à.d. par photolithographie et électroformage, dans les volumes déterminés par les photomasques 9 et/ou 9' permettent de réaliser des pièces avec un contour très complexes, difficiles ou même impossible à produire avec des technologies d'usinage classiques par enlèvement de copeaux, électroérosion ou la découpe laser. Avantageusement, cette pièce comporte par exemple des ouvertures de forme complexe, afin de rendre la reproduction difficile pour le contrefacteur dépourvu de l'équipement adéquat.

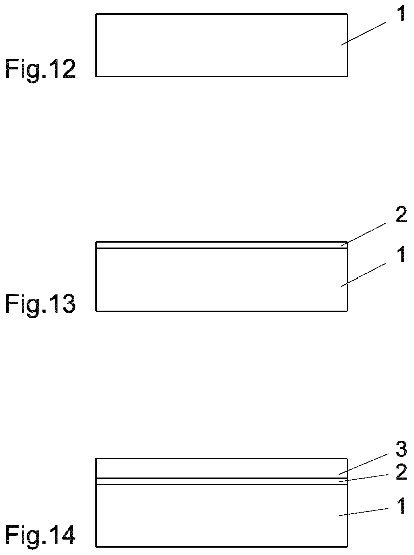

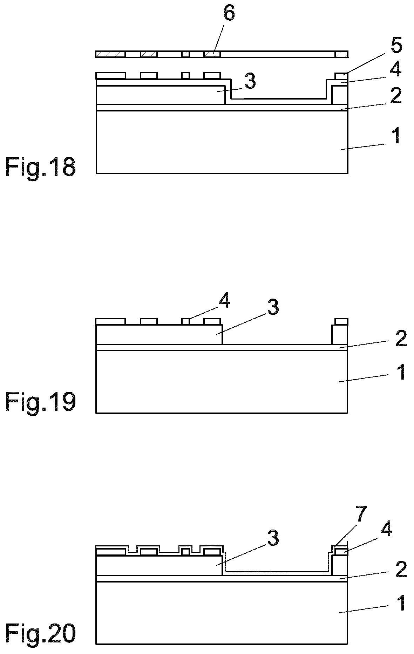

Les figures 12 à 24 illustrent un deuxième mode de réalisation de l'invention permettant de réaliser des pièces avec plusieurs niveaux définis par au moins un quatrième photomasque 11 et un motif CLR défini par le premier photomasque 6.

Selon la figure 13, une couche conductrice 2 est déposée sur un substrat 1 en silicium, verre, métal etc. Une couche de résine photosensible 3 est ensuite déposée au cours de l'étape illustrée sur la figure 14. L'épaisseur de cette couche 3 détermine les différences de niveau de la pièce finale ; elle peut être par exemple entre 10 et 1000 microns.

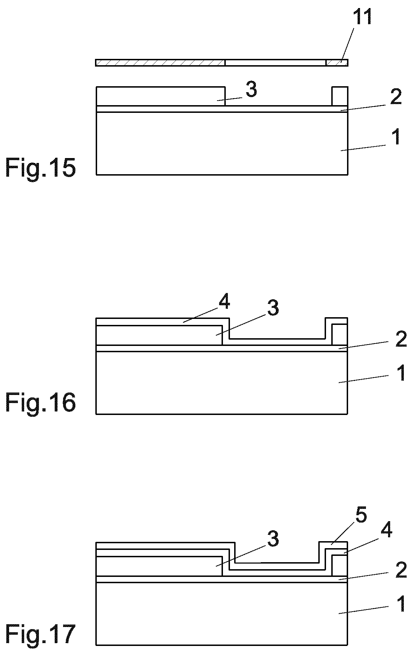

La couche de résine photosensible 3 est ensuite illuminée au travers d'un troisième masque 11 dont les ouvertures déterminent le premier niveau de la pièce finale (figure 15). Il en résulte un substrat 1 recouvert d'une couche conductrice 2 ainsi que, sélectivement, de portions de résine 3.

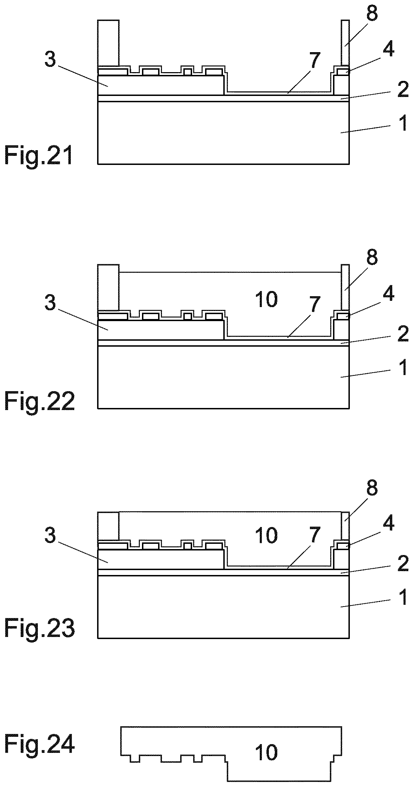

Les étapes suivantes illustrées sur les figures 16 à 24 correspondent aux étapes correspondantes des figures 1 à 11, permettant tout d'abord de créer sur le substrat résultant de la figure 15 un ou plusieurs motifs CLR, puis de faire croitre par électroformage au-dessus de ce motif une ou plusieurs pièces 11. La pièce résultante 10, illustrée sur la figure 24, comporte donc plusieurs niveaux, dans cet exemple deux niveaux, dont l'un au moins est muni d'un motif CLR 100.

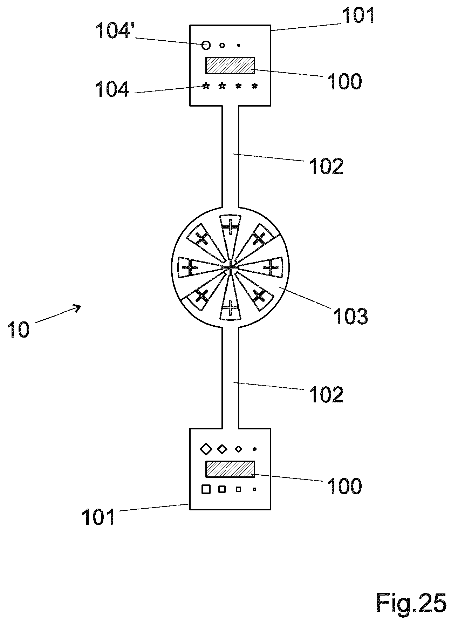

Le procédé de l'invention peut notamment être appliqué à la fabrication de pièces horlogères, tel qu'un composant du mouvement comme la roue d'échappement, une roue, un pont, une platine, une bascule etc, ou un élément d'habillage tel qu'une applique de cadran, un réhaut, une aiguille etc. La figure 25 illustre un autre mode de réalisation dans lequel la pièce 10 fabriquée avec l'un des procédés décrits plus haut est constituée par un sceau, destiné à sceller un paquet, une boîte, une porte etc. Le sceau 10 est prévu de manière à empêcher l'ouverture du paquet, de la porte etc sans détruire le sceau. D'autre part, le sceau doit être aussi difficile que possible à reproduire pour éviter qu'un intrus qui accède de manière non autorisée à l'objet ou au lieu scellé ne remplace le sceau par une copie.

Le sceau 10 illustré à titre d'exemple sur la figure 25 est un sceau métallique comportant deux parties 101 destinées à être collées, rivetées, ou fixées de manière inamovible sur deux parties de l'objet à protéger, par exemple sur les deux volets d'un paquet, d'une enveloppe, sur le battant et le cadre d'une porte, etc. Une partie centrale 103 est reliée par deux ponts 102 à ces deux points de fixation. L'épaisseur des deux parties de fixation 101 est de préférence suffisante pour permettre une fixation solide et rigide sur l'objet à protéger ; une épaisseur comprise entre 100 et 500 microns peut avantageusement être utilisée, par exemple 300 microns. Les deux ponts 102 et la partie centrale 103 peuvent être plus fins pour faciliter leur déchirement, ou avoir la même épaisseur que les parties de fixation 101.

La partie centrale 103 est munie d'un motif complexe, difficile à produire par usinage ou électroérosion, comportant en particulier de nombreuses ouvertures circulaires ou de forme complexe et fine, dans cet exemple des segments de cercle avec des croix. D'autres motifs complexes, y compris des logos, des textes, etc peuvent être utilisés. Ce motif complexe est obtenu grâce au deuxième photomasque 9 lors des étapes illustrées sur les figures 9 respectivement 21 ci-dessus. De la même façon, au moins une des portions de fixation 101 est munie d'ouvertures ou de motifs 104, 104'définis par le deuxième photomasque 9. Une première protection contre la reproduction est ainsi obtenue grâce à cette forme complexe, difficile à reproduire avec des procédés d'usinage courants, et difficile à reproduire même pour celui qui dispose du procédé LIGA nécessaire mais pas du deuxième photomasque 9.

Une protection supplémentaire est obtenue en munissant au moins un portion de la pièce 10 d'un motif CLR 100, pratiquement invisible à l'oeil nu, mais qui permet de projeter un motif très visible dans des conditions d'illumination données, par exemple avec une source de lumière cohérente. Dans l'exemple illustré, chaque portion de fixation 101 est munie d'une telle surface CLR 100. Il est bien entendu aussi possible de munir la portion centrale 103, au d'autres portions, d'un tel motif défini à l'aide du premier photomasque 6. Une deuxième protection contre la reproduction est ainsi obtenue grâce à ce motif CLR, difficile à reproduire avec des procédés d'usinage courants, et difficile à reproduire même pour celui qui dispose du procédé nécessaire mais pas du premier photomasque 6.

Il est possible de réaliser avec cette technologie des motifs CLR comportant de 50x50 jusqu'à 10'000 x 10'000 pixels, par exemple 256x256 pixels ; la taille des pixels peut être par exemple comprise entre 0,5 et 5 microns.

## Revendications

1. Procédé de fabrication de pièce (10) comportant les étapes suivantes :
a) nanostructuration d'un motif CLR (Covert Laser Readable) sur un substrat (1);
e) déposition d'une couche conductrice (7) par-dessus le substrat respectivement par-dessus des portions de couche diffractive (4) sur ce substrat ;
f) déposition d'une deuxième couche de résine photosensible (8) ;
g) illumination de ladite deuxième couche de résine photosensible (8) au travers d'un deuxième photomasque (9), de manière à supprimer sélectivement des portions de ladite deuxième résine photosensible (8) ;
h) déposition de matière (10) par électroformage au-dessus de ladite couche conductrice (7), entre les portions subsistantes de deuxième résine photosensible (8) ;
i) libération de la pièce (10) par enlèvement au moins de la deuxième résine photosensible (8).

2. Procédé selon la revendication 1, dans lequel la phase de nanostructuration comporte les étapes suivantes :
A') déposition d'une première couche de résine photosensible (5);
b) illumination de ladite première couche de résine photosensible au travers d'un premier photomasque (6), de manière à supprimer sélectivement des portions de ladite résine photosensible ;
c) gravure aux endroits non recouverts par ladite première couche de résine photosensible (5);
d) suppression de la première couche de résine photosensible (5).

3. Procédé selon la revendication 1, dans lequel la phase de nanostructuration est effectuée par nano-imprint-lithographie (NIL).

4. Procédé selon la revendication 2, la première couche de résine photosensible (5) étant plus fine que la seconde couche de résine photosensible (8).

5. Procédé selon l'une des revendications 2, ou 4, ladite première couche de résine photosensible étant déposée sur un substrat (1) recouvert d'une couche diffractive (4).

6. Procédé selon l'une des revendications 2, ou 4, ladite première couche de résine photosensible étant déposée sur un substrat (1) de type SOI.

7. Procédé selon l'une des revendications 2 ou 4 à 6, dans lequel la résolution dudit premier photomasque (6) est inférieure à 10 microns.

8. Procédé selon l'un des revendications 2, ou 4 à 7, dans lequel ledit premier photomasque (6) permet de faire subsister une ou plusieurs portions non contiguës de couches diffractives, la surface de chaque portion étant inférieure à 4mm².

9. Procédé selon l'une des revendications 2 ou 4 à 8, comportant une étape de libération des portions électroformées afin de créer plusieurs pièces (10) à partir d'un seul substrat (1).

10. Procédé selon l'une des revendications 1, 2 ou 4 à 9, dans lequel la gravure permet de créer ledit motif CLR.

11. Procédé selon l'une des revendications 1,2 ou 4 à 10, dans lequel ledit substrat (1) est en verre, en semiconducteur ou en métal ;
ladite étape de libération de la pièce (10) comportant une étape d'enlèvement dudit substrat.

12. Procédé selon l'une des revendications 1, 2, ou à 4 à 11, dans lequel ladite couche diffractive (4) est déposée sur ledit substrat (1) recouvert d'une couche conductrice (2), elle-même sélectivement recouverte d'une troisième couche de résine photosensible (3).

13. Procédé selon l'une des revendications 1 à 12, comportant la déposition d'une troisième couche de résine photosensible (8') d'épaisseur inférieure à ladite deuxième couche de résine photosensible (8), puis l'illumination de ladite troisième couche de résine photosensible (8') au travers d'un troisième photomasque (9'), de manière à supprimer sélectivement des portions de ladite troisième couche de résine photosensible (8') et à réaliser ainsi un trou borgne dans la pièce.

14. Pièce micromécanique (10) fabriquée selon le procédé de l'une des revendications précédentes.

15. Pièce micromécanique selon la revendication 14, **caractérisée en ce que** les motifs micrométriques sont en creux ou en relief.

16. Pièce micromécanique selon l'une des revendications 14 ou 15, **caractérisée en ce que** les motifs micrométriques sont étagés sur plusieurs niveaux.

17. Pièce micromécanique selon l'une des revendications 14 à 16, constituée par un composant horloger.

18. Pièce micromécanique selon l'une des revendications 14 à 16 constituée par un sceau.

19. Pièce micromécanique selon la revendication 18, ledit sceau comportant :
deux portions de fixation (101) reliées entre elles par au moins un pont (102) ;
au moins une ouverture non circulaire (104) ;
au moins une portion (100) constituant un motif CLR.

## Patentansprüche

1. Verfahren zur Herstellung eines Teils (10), mit den folgenden Schritten:
a) Nanostrukturierung eines CLR (Covert Laser Readable) Musters auf einem Substrat (1);
e) Abscheidung einer leitfähigen Schicht (7) über das Substrat bzw. über die Portionen der Lichtbeugungsschicht (4) auf diesem Substrat;
f) Abscheidung einer zweiten lichtempfindlichen Harzschicht (8);
g) Illumination der besagten zweiten lichtempfindlichen Harzschicht (8) durch eine zweite Fotomaske (9) hindurch, um somit selektiv Portionen des besagten zweiten lichtempfindlichen Harzes (8) zu entfernen;
h) Abscheidung durch Galvanoformung von Material (10) über die besagte leitfähige Schicht (7) zwischen den verbleibenden Portionen der zweiten lichtempfindlichen Harzschicht (8);
i) Freigabe des Teils (10) durch Entfernen mindestens des zweiten lichtempfindlichen Harzes (8).

2. Verfahren gemäss Anspruch 1, worin die Nanostrukturierungsphase die folgenden Schritte umfasst:
A') Abscheidung einer ersten lichtempfindlichen Harzschicht (5);
b) Illumination der besagten ersten lichtempfindlichen Harzschicht durch eine erste Fotomaske (6) hindurch, um somit selektiv Portionen des besagten lichtempfindlichen Harzes;
c) Ätzung an den Stellen, welche durch die besagte erste lichtempfindliche Harzschicht (5) nicht abgedeckt wurden;
d) Entfernen der ersten lichtempfindlichen Harzschicht (5).

3. Verfahren gemäss Anspruch 1, worin die Nanostrukturierungsphase mittels Nanoimprint-Lithografie (NIL) durchgeführt wird.

4. Verfahren gemäss Anspruch 2, worin die erste lichtempfindliche Harzschicht (5) dünner als die zweite lichtempfindliche Harzschicht (8) ist.

5. Verfahren gemäss einem der Ansprüche 2 oder 4, worin die besagte erste lichtempfindliche Harzschicht auf ein durch eine Lichtbeugungsschicht (4) bedecktes Substrat (1) abgeschieden wird.

6. Verfahren gemäss einem der Ansprüche 2 oder 4, worin die besagte erste lichtempfindliche Harzschicht auf ein Substrat (1) vom Typ SOI abgeschieden wird.

7. Verfahren gemäss einem der Ansprüche 2, oder 4 bis 6, worin die Auflösung der besagten ersten Fotomaske (6) weniger als 10 Mikron beträgt.

8. Verfahren gemäss einem der Ansprüche 2, oder 4 bis 7, worin die besagte erste Fotomaske (6) es ermöglicht, eine oder mehrere nicht aneinander angrenzenden Portionen von Lichtbeugungsschichten überstehen zu lassen, wobei die Fläche jeder Portion weniger als 4mm² beträgt.

9. Verfahren gemäss einem der Ansprüche 2, oder 4 bis 8, mit einem Schritt, die galvanogeformten Portionen freizugeben, um mehrere Teile (10) aus einem einzigen Substrat (1) herzustellen.

10. Verfahren gemäss einem der Ansprüche 1, 2, oder 4 bis 9, worin die Ätzung die Erschaffung des besagten CLR-Musters erlaubt.

11. Verfahren gemäss einem der Ansprüche 1, 2, oder 4 bis 10, worin das besagte Substrat (1) aus Glas, Halbleiter oder Metall hergestellt ist;
worin der besagte Schritt der Freigabe des Teils (10) den Schritt der Entfernung des besagten Substrats umfasst.

12. Verfahren gemäss einem der Ansprüche 1, 2, oder 4 bis 11, worin die besagte Lichtbeugungsschicht (4) auf das besagte Substrat (1) abgeschieden wird, welches mit einer leitfähigen Schicht (2) überzogen ist, welche ihrerseits selektiv mit einer dritten lichtempfindlichen Harzschicht (3) bedeckt ist.

13. Verfahren gemäss einem der Ansprüche 1 bis 12, mit der Abscheidung einer dritten lichtempfindlichen Harzschicht (8') mit einer geringeren Dicke als die besagte zweite lichtempfindliche Harzschicht (8) und dann die Illumination der besagten dritten lichtempfindlichen Harzschicht (8') durch eine dritte Fotomaske (9') hindurch, um somit Portionen der besagten dritten lichtempfindlichen Harzschicht (8') selektiv zu entfernen und somit ein Blindloch im Teil herzustellen.

14. Feinmechanikteil (10), das gemäss dem Verfahren von einem der vorhergehenden Ansprüche hergestellt wurde.

15. Feinmechanikteil gemäss Anspruch 14, **dadurch gekennzeichnet, dass** die mikrometrischen Muster eingestanzt oder eingeprägt sind.

16. Feinmechanikteil gemäss einem der Ansprüche 14 oder 15, **dadurch gekennzeichnet, dass** die mikrometrischen Muster über mehrere Ebenen abgestuft sind.

17. Feinmechanikteil gemäss einem der Ansprüche 14 bis 16, bestehend aus einer Uhrmachereikomponente.

18. Feinmechanikteil gemäss einem der Ansprüche 14 bis 16, bestehend aus einem Siegel.

19. Feinmechanikteil gemäss Anspruch 18, worin das besagte Siegel umfasst:
zwei Befestigungsteile (101), welche über mindestens eine Brücke (102) miteinander verbunden sind;
mindestens eine nichtkreisförmige Öffnung (104);
mindestens eine Portion (100), welche ein CLR-Muster bildet.

## Claims

1. Method for manufacturing a part (10), comprising the following steps:
a) nanostructuring of a CLR (Covert Laser Readable) pattern on a substrate (1);
e) deposition of a conductive layer (7) above the substrate respectively above the diffractive layer portions (4) on this substrate;
f) deposition of a second photosensitive resin layer (8);
g) illumination of said second photosensitive resin layer (8) through a second photomask (9), so as to selectively remove portions of said second photosensitive resin (8);
h) electroforming-based deposition of matter (10) on top of said conductive layer (7) between the remaining portions of the second photosensitive resin (8);
i) release of the part (10) by removal of at least the second photosensitive resin (8).

2. Method according to claim 1, wherein the nanostructuring phase comprises the following steps:
A') deposition of a first photosensitive resin layer (5);
b) illumination of said first photosensitive resin layer through a first photomask (6) so as to selectively remove portions of said photosensitive resin;
c) etching in the areas not covered by said first photosensitive resin layer (5);
d) removal of the first photosensitive resin layer (5).

3. Method according to claim 1, wherein the nanostructuring phase is performed by nano-imprint lithography (NIL).

4. Method according to claim 2, wherein the first photosensitive resin layer (5) is thinner than the second photosensitive resin layer (8).

5. Method according to one of the claims 2 or 4, wherein said first photosensitive resin layer is deposited onto a substrate (1) covered by a diffractive layer (4).

6. Method according to one of the claims 2 or 4, wherein said first photosensitive resin layer is deposited on a SOI-type substrate (1).

7. Method according to one of the claims 2, or 4 to 6, wherein the resolution of said first photomask (6) is lower than 10 microns.

8. Method according to one of the claims 2, or 4 to 7, wherein said first photomask (6) enables one or several non-contiguous portions of diffractive layers to survive, wherein the surface of each portion is less than 4mm².

9. Method according to one of the claims 2, or 4 to 8, comprising a step of releasing the electroformed portions in order to create several parts (10) from a single substrate (1).

10. Method according to one of the claims 1, 2, or 4 to 9, wherein the etching enables said CLR pattern to be created.

11. Method according to one of the claims 1, 2, or 4 to 10, wherein said substrate (1) is made of glass, semi-conductor or metal;
wherein said step of releasing the part (10) comprises a step of removing said substrate.

12. Method according to one of the claims 1, 2, or 4 to 11, wherein said diffractive layer (4) is deposited onto said substrate (1) covered with a conductive layer (2), itself selectively covered with a third photosensitive resin layer (3).

13. Method according to one of the claims 1 to 12, comprising the deposition of a third photosensitive resin layer (8') with a thickness less than said second photosensitive resin layer (8) and then the illumination of said third photosensitive resin layer (8') through a third photomask (9') so as to selectively remove portions of said third photosensitive resin layer (8') and to thus produce a blind hole in the part.

14. Micromechanical part (10) manufactured according to the method of one of the preceding claims.

15. Micromechanical part according to claim 14, **characterized in that** the micro-scale patterns are stamped or embossed.

16. Micromechanical part according to one of the claims 14 or 15, **characterized in that** the micro-scale patterns are tiered over several levels.

17. Micromechanical part according to one of the claims 14 to 16, constituted of a watchmaking component.

18. Micromechanical part according to one of the claims 14 to 16, constituted by a seal.

19. Micromechanical part according to claim 18, wherein said seal comprises:
two fastening portions (101) connected to one another by at least one bridge (102);
at least one non-circular opening (104);
at least one portion (100) constituting a CLR pattern.
